(19) Europäisches Patentamt
European Patent Office
Office européen des brevets

(11) **EP 1 429 150 B1**

(12) **FASCICULE DE BREVET EUROPEEN**

(45) Date de publication et mention
de la délivrance du brevet:
**11.07.2007 Bulletin 2007/28**

(51) Int Cl.:
**G01R 31/06** (2006.01)

(21) Numéro de dépôt: **03104592.5**

(22) Date de dépôt: **08.12.2003**

(54) **Procédé pour diagnostiquer un défaut sur un enroulement de transformateur**

Verfahren zur Diagnose eines Fehlers in einer Transformatorwindung

Diagnostic method for a fault in a transformer winding

(84) Etats contractants désignés:
**AT BE BG CH CY CZ DE DK EE ES FI FR GB GR HU IE IT LI LU MC NL PT RO SE SI SK TR**

(30) Priorité: **10.12.2002 FR 0215590**
**07.02.2003 FR 0301499**

(43) Date de publication de la demande:
**16.06.2004 Bulletin 2004/25**

(73) Titulaire: **Areva T&D SA**
**92309 Levallois-Perret Cedex (FR)**

(72) Inventeur: **Ryder, Simon**
**75019 PARIS (FR)**

(74) Mandataire: **Poulin, Gérard et al**
**Brevatome**
**3, rue du Docteur Lancereaux**
**75008 Paris (FR)**

(56) Documents cités:
**WO-A-02/35248          US-B1- 6 466 034**

- **RYDER S A: "METHODS FOR COMPARING FREQUENCY RESPONSE ANALYSIS MEASUREMENTS" , CONFERENCE RECORD OF THE 2002 IEEE INTERNATIONAL SYMPOSIUM ON ELECTRICAL INSULATION. (ISEI 2002). BOSTON, MA, APRIL 7 - 10, 2002, INTERNATIONAL SYMPOSIUM ON ELECTRICAL INSULATION, NEW YORK, NY: IEEE, US, PAGE (S) 187-190 XP001162794 ISBN: 0-7803-7337-5 * page 187, colonne de gauche - page 188, colonne de gauche; figure 1; tableau 1 * * page 190, colonne de gauche ***

**Description**

La présente invention concerne un procédé pour diagnostiquer un défaut sur un enroulement de transformateur utilisant une analyse de réponse en fréquence ou FRA (Fréquence Response Analysis en anglais). La présente invention est plus particulièrement adaptée aux transformateurs de puissance.

Les transformateurs de puissance (tels que des transformateurs ayant des tensions primaires de plusieurs centaines de kV et des puissances délivrées allant de quelques MVA à plusieurs centaines de MVA) sont des dispositifs extrêmement coûteux dans les systèmes d'interconnexion des réseaux de transmission. Il est donc très utile de pouvoir garder en service ces transformateurs le plus longtemps possible, une panne ou un défaut du transformateur pouvant avoir des conséquences économiques importantes dues à l'arrêt du réseau de distribution.

En outre, des défauts tels que des courts-circuits peuvent entraîner des risques d'explosion ou d'incendie.

Il est donc très important de pouvoir déterminer la présence de défaut lié à l'enroulement d'un transformateur.

Une solution connue à ce problème consiste à utiliser une analyse de réponse en fréquence appelée usuellement FRA (Frequency Response Analysis en anglais). Cette technique consiste à mesurer l'impédance d'un enroulement de transformateur sur une large gamme de fréquence et à comparer le résultat de ces mesures avec un ensemble de référence. Afin de mesurer l'impédance en fonction de la fréquence, on peut effectuer un balayage en fréquence en utilisant un signal sinusoïdal.

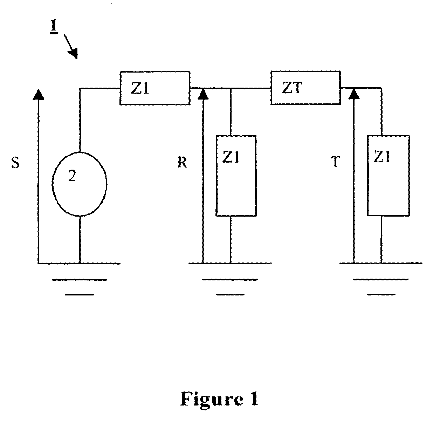

Ainsi, la figure 1 représente un schéma de principe d'un circuit 1 d'analyse en fréquence d'une impédance correspondant à l'impédance d'un enroulement de transformateur à mesurer.

Le circuit 1 comporte :

- un analyseur de réseau 2,
- trois impédances de test de même valeur Z1,
- une impédance ZT correspondant à l'impédance d'un enroulement de transformateur à mesurer.

L'analyseur de réseau 2 génère un signal S de mesure. Le signal S de mesure est un signal sinusoïdal balayé en fréquence. Les impédances Z1 sont par exemple les impédances des câbles de mesure et ont généralement une valeur égale à 50 Ohms. R est le signal mesuré entre la première extrémité de ZT et la masse. T est le signal mesuré entre la deuxième extrémité de ZT et la masse. L'analyseur 2 représente ensuite en fonction de la fréquence le gain en tension k défini par la relation suivante :

$$k = 20\log_{10}\left(\frac{T}{R}\right).$$

Le gain k contient les informations nécessaires à l'étude de l'impédance ZT et vaut :

$$k = 20\log_{10}\left(\frac{Z1}{Z1 + ZT}\right).$$

Dans le cas d'une impédance Z1 égale à 50 Ohms, on a ainsi :

$$k = 20\log_{10}\left(\frac{50}{50 + ZT}\right).$$

L'impédance est mesurée sur une gamme très large de fréquence qui peut aller de quelques Hz à une dizaine de MHz.

La même mesure doit être effectuée sur un enroulement de référence. Cet enroulement de référence peut être soit une autre phase pour laquelle on fait l'hypothèse qu'il n'y a pas de défaut, soit le même enroulement sans défaut mesuré auparavant, soit l'enroulement d'un transformateur identique. On obtient donc également un gain k' en fonction de la fréquence correspondant à cet enroulement de référence.

Une première solution consiste alors à examiner à l'oeil les différences entre les courbes représentant k et k' en fonction de la fréquence. Cette solution présente cependant certains problèmes.

En effet, l'examen à l'oeil effectué par un expert peut présenter une grande subjectivité et manquer de transparence.

Une deuxième solution consiste à calculer des indicateurs statistiques permettant de mettre en évidence les différences entre les deux courbes. De tels indicateurs statistiques sont par exemple les coefficients de corrélation calculés dans différentes gammes de fréquences.

Toutefois, l'utilisation de ces indicateurs statistiques pose également certains problèmes.

Ainsi, certains défauts ne peuvent pas être identifiés ; c'est le cas par exemple d'une mise à la terre du circuit magnétique du transformateur ou d'un courant de circulation produisant un échauffement de l'enroulement.

De même, cette utilisation des indicateurs statistiques peut conduire à confondre certains défauts ; par exemple, une mauvaise mise à la terre de la cuve du transformateur peut être confondue avec un endommagement de l'enroulement.

Un procédé selon l'état de la technique antérieure est décrit dans le document : S.A. Ryder "Methods for comparing frequency response analysis measurements", Conf. Rec. 2002 IEEE Int. Symp. on Electrical Insulation, Boston, MA USA, 7.-10.04.2002.

La présente invention vise à fournir un procédé pour diagnostiquer un défaut sur un enroulement de transformateur permettant à la fois d'augmenter le nombre de défauts détectables et de distinguer les différents défauts entre eux.

La présente invention propose à cet effet un procédé pour diagnostiquer un défaut sur un enroulement de transformateur selon la revendication 1 comportant au moins les étapes suivantes :

- mesure de l'impédance dudit enroulement en fonction de la fréquence, ladite mesure étant représentée sous la forme d'un premier gain en tension,
- comparaison de ladite mesure de l'impédance avec une mesure de référence représentée sous la forme d'un deuxième gain en tension, ladite comparaison incluant une étape de calcul de trois premiers paramètres, chacun desdits trois premiers paramètres étant un coefficient de corrélation desdits premier et deuxième gain dans trois gammes de fréquence différentes,

ledit procédé comporte une étape de détermination de la variation relative d'au moins un quatrième paramètre, ledit quatrième paramètre étant une grandeur physique caractéristique dudit transformateur, ladite variation relative étant obtenue en comparant lesdits premier et deuxième gains.

Grâce à l'invention, on combine les trois coefficients de corrélation avec la variation relative d'au moins un quatrième paramètre permettant d'identifier certains défauts non détectés par les valeurs des coefficients de corrélation. Selon la valeur de la variation relative de ce quatrième paramètre, il est également possible de lever une incertitude entre différents défauts possibles.

Avantageusement, ledit quatrième paramètre est choisi parmi le gain minimal, la fréquence de résonance fondamentale ou le nombre de fréquences de résonance présentes au-delà d'une fréquence prédéterminée.

Avantageusement, ledit gain minimal est déterminé pour une fréquence inférieure à 10 kHz.

Le gain minimal se définit comme la valeur minimale prise par le gain en tension k tel que décrit en référence à la figure 1 en fonction de la fréquence de mesure ; le gain minimal à déterminer est le gain minimal pour une fréquence inférieure à 10 kHz. Il se peut en effet que le gain prenne une valeur minimale pour une fréquence plus élevée mais cette valeur est moins pertinente pour l'identification des défauts.

Avantageusement, lesdites trois gammes de fréquence différentes sont respectivement [1 kHz-10kHz], [10kHz-100kHz] et [1 00kHz-1 MHz].

Il apparaît en effet que les coefficients de corrélation calculés en dessous de 1 kHz sont moins pertinents et que ceux calculés au-delà de 1 MHz donnent des informations peu fiables.

Selon un mode de réalisation particulièrement avantageux, ledit procédé comporte une étape de détermination de la variation relative d'au moins un cinquième et un sixième paramètre, lesdits cinquième et sixième paramètres étant caractéristiques dudit transformateur, ladite variation relative étant obtenue en comparant lesdits premier et deuxième gains.

Selon ce mode de réalisation, ledit quatrième paramètre est le gain minimal, ledit cinquième paramètre est la fréquence de résonance fondamentale et ledit sixième paramètre est le nombre de fréquences de résonance présentes au-delà d'une fréquence prédéterminée.

De manière extrêmement avantageuse, ledit procédé comporte une étape de détermination d'une pluralité de codes de diagnostic, chacun desdits codes indiquant l'appartenance d'un desdits paramètres à une gamme de valeurs prédéterminée.

Selon ce dernier mode de réalisation, ledit procédé comporte une étape de détermination de la présence d'un défaut et d'identification dudit défaut en fonction de ladite pluralité de codes de diagnostic.

Avantageusement, ladite étape de détermination de la présence d'un défaut et d'identification dudit défaut se fait par comparaison de ladite pluralité de codes avec des codes enregistrés dans une table de recherche.

D'autres caractéristiques et avantages de la présente invention apparaîtront dans la description suivante d'un mode de réalisation de l'invention, donné à titre illustratif et nullement limitatif.

Dans les figures suivantes :

- La figure 1 représente schématiquement un circuit d'analyse de réponse en fréquence d'une impédance,
- La figure 2 représente schématiquement un transformateur triphasé,
- La figure 3 représente les gains respectifs en fonction de la fréquence de deux enroulements haute tension de deux phases d'un transformateur triphasé.

La figure 1 a déjà été décrite en relation avec l'état de la technique. Les mesures FRA présentées par la suite seront toujours réalisées à partir d'un circuit d'analyse tel que représenté en figure 1.

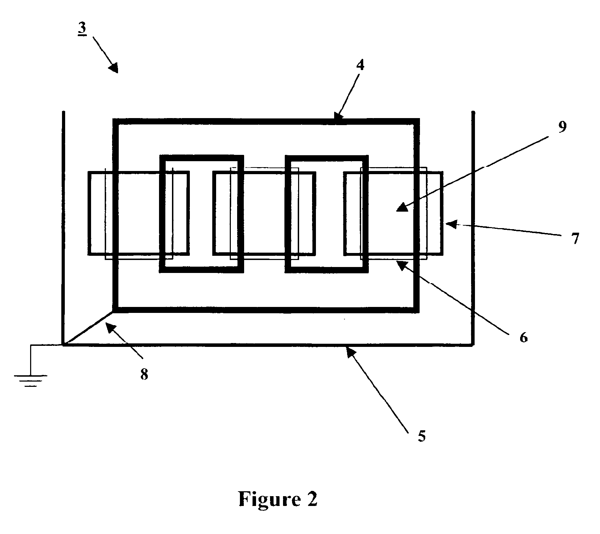

La figure 2 représente schématiquement un transformateur triphasé 3.

Le transformateur triphasé 3 comprend :

- un circuit magnétique 4,
- une cuve 5,
- trois enroulements basse tension 6,
- trois enroulements haute tension 7.

Chaque couple d'enroulement haute et basse tension correspond à une phase du transformateur associée à un noyau 9 du circuit 4. Les trois phases du transformateur seront respectivement notées par la suite A, B et C.

Le circuit magnétique 4 et la cuve 5 sont reliés par une liaison 8 et sont à la masse.

Trois mesures d'impédance peuvent être effectuées respectivement pour la haute et la basse tension.

Ainsi, si on suspecte un défaut sur l'un des enroulements haute tension du transformateur, on mesure le gain de cet enroulement en fonction de la fréquence, on effectue la même mesure pour un autre enroulement haute fréquence et on compare les gains respectifs de ces deux enroulements. Notons qu'une troisième mesure est également possible en utilisant le troisième enroulement haute fréquence.

Notons que l'on peut également effectuer une comparaison entre les mesures sur l'enroulement soupçonné et des mesures réalisées antérieurement sur le même enroulement. On peut aussi faire une comparaison entre les mesures sur l'enroulement soupçonné et un enroulement équivalent d'un autre transformateur de la même conception.

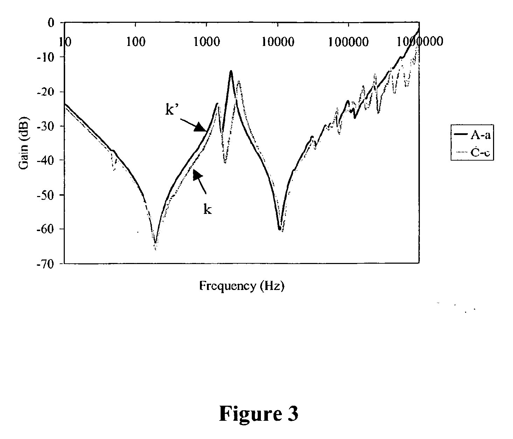

A titre d'exemple, la figure 3 représente les gains k et k' respectifs de deux enroulements haute tension des phases respectives C et A d'un transformateur triphasé tel que celui représenté en figure 2.

Les gains k et k' sont représentés pour une fréquence variant de 10 Hz à 1 MHz.

On suspecte la présence d'un défaut sur l'enroulement haute fréquence de la phase C correspondant au gain k.

Afin de déterminer la présence d'un éventuel défaut et de diagnostiquer ce dernier, le procédé selon l'invention comporte le calcul de six paramètres.

Les trois premiers paramètres sont les coefficients de corrélation $\rho_1$, $\rho_2$ et $\rho_3$ de k et k' calculés sur les trois gammes de fréquences [1 kHz-10kHz], [10kHz-100kHz] et [100kHz-1MHz].

Rappelons que le coefficient de corrélation $\rho$ pour deux ensembles de n nombres $X \{x_1, x_2, ... , x_n\}$ et $Y\{y_1, y_2, ... , y_n\}$ est défini par la relation :

$$\rho = \sum_{x=i}^{n} x_i y_i \left/ \sqrt{\sum_{i=1}^{n} x_i^2 \sum_{i=1}^{n} y_i^2} \right. .$$

Le quatrième paramètre est défini comme le changement relatif du gain minimal $CR_k$ en basse fréquence, c'est à dire à une valeur de fréquence inférieure à 10 kHz. Ainsi, si on appelle $k_m$ le gain minimal de l'impédance à analyser et $k'_m$ le gain minimal de l'impédance de référence, le coefficient de changement relatif de gain minimal $CR_k$

est défini par la relation : $CR_k = \dfrac{k_m}{k'_m}$ .

Le cinquième paramètre est défini comme le changement relatif de la fréquence de résonance fondamentale $CR_f$. La fréquence de résonance fondamentale est la première fréquence de résonance de chacun des gains k et k'. Si on appelle f et f' les fréquences de résonance fondamentales respectives des gains k et k', le paramètre $CR_f$ est défini

par la relation : $CR_f = \dfrac{f}{f'}$ .

Le sixième paramètre est défini comme le changement relatif du nombre de fréquences de résonance comprises entre 100 kHz et 1 MHz. Si on appelle n et n' le nombre de fréquences de résonance respectives de k et k' comprises entre 100 kHz et 1 MHz, le paramètre $CR_n$ est défini par la relation : $CR_n = \dfrac{n}{n'}$ .

A chaque mesure du gain k comparée à une mesure du gain de référence k' correspond donc un sextuplet de paramètres $\{\rho_1, \rho_2, \rho_3, CR_k, CR_f, CR_n\}$.

Ces paramètres peuvent être calculés soit en utilisant un outil informatique soit par un opérateur en utilisant une feuille MSExcel® ou un autre tableur.

Ainsi, en calculant ces paramètres pour les courbes représentées en figure 3, on obtient:

$\rho_1 = 0{,}7483$
$\rho_2 = 0{,}9797$
$\rho_3 = 0{,}8577$
$CR_k = 0{,}9717$
$CR_f = 1$
$CR_n = 1{,}8333$.

On associe ensuite à chacune de ces valeurs un code ; l'ensemble de ces codes est résumé dans le tableau 1 ci-dessous.

**Tableau 1**

| Paramètres | Valeurs | Codes |
|---|---|---|
| $\rho$ **(valable pour toutes les gammes de fréquences)** | Plage normale | 0 |
| | >0,7000 | 1 |
| | <0,7000 | 2 |
| **$CR_f$** | < Plage normale | 9 |
| | Suppression de la fréquence | 8 |
| | Plage normale | 0 |
| | Plage normale - 1,25 | 1 |
| | 1,25 - 1,5 | 2 |
| | 1,5-5 | 3 |
| | >5 | 4 |
| **$CR_k$** | > Plage normale | 9 |
| | Plage normale | 0 |
| | >0,8 | 1 |
| | 0,2 - 0,8 | 2 |
| | <0,2 | 3 |
| **$CR_n$** | Plage normale | 0 |
| | > Plage normale | 1 |

Ainsi, on peut associer six codes à chaque sextuplet $\{\rho_1, \rho_2, \rho_3, CR_k, CR_f, CR_n\}$.

Le terme « plage normale » signifie que le paramètre se trouve à l'intérieur d'une plage de variation dite normale.

Cette plage de variation normale dépend de l'enroulement utilisé pour la mesure de référence. Le tableau 2 résume les variations normales dans le cas où le même enroulement est utilisé pour les mesures d'analyse et de référence.

**Tableau 2**

| Paramètres | Plages normales |
|---|---|
| ρ (valable pour toutes les gammes de fréquences) | [0,9950 - 1,0000] |
| CR$_f$ | [0,9000 - 1,1000] |
| CR$_k$ | $$\left[ \frac{k_m' - 6}{k_m'} - \frac{k_m' + 6}{k_m'} \right]$$ |
| CR$_n$ | 1,2000 |

Le tableau 3 résume les variations normales dans le cas où un enroulement différent est utilisé pour la référence (cas de la figure 3).

**Tableau 3**

| Paramètres | Plages normales |
|---|---|
| ρ (valable pour toutes les gammes de fréquences) | [0,9750 - 1,0000] |
| CR$_f$ | [0,6500 - 1,5000] |
| CR$_k$ | $$\left[ \frac{k_m' - 6}{k_m'} - \frac{k_m' + 6}{k_m'} \right]$$ |
| CR$_n$ | 1,2000 |

Les paramètres {ρ$_1$, ρ$_2$, ρ$_3$, CR$_k$, CR$_f$, CR$_n$} pour les courbes représentées en figure 3 donnent donc les codes : 101001.

Lorsque les six codes sont déterminés, le procédé selon l'invention comporte une étape de comparaison de ces six codes avec des codes enregistrés dans une table de recherche telle que présentée dans le tableau 4.

**Tableau 4**

| Types de fautes | ρ$_1$ | ρ$_2$ | ρ$_3$ | CR$_f$ | CR$_k$ | CR$_n$ |
|---|---|---|---|---|---|---|
| 1) Pas de faute | 0 | 0 | 0 | 0 | 0 | 0 |
| 2) Mauvaise mise à la terre de la cuve (haute résistance) | 0 | 0 | 0-1 | 0 | 0 | 0 |
| 3) Absence de mise à la terre de la cuve | 0 | 0 | 0-1 | 0-9 | 0-1 | 0 |
| 4) Absence de mise à la terre du circuit magnétique | 0 | 0 | 0 | 0-9 | 0-1 | 0 |
| 5) Boucle fermée mise à la terre | 0 | 0 | 0 | 0-9 | 0 | 0 |
| 6) Boucle fermée mise à un potentiel flottant | 0 | 0 | 0-1 | 0-9 | 0 | 0 |
| 7) Spire additionnelle en court- circuit (même phase) | 0-1-2 | 0 | 0 | 3 | 2-3 | 0 |
| 8) Défaut entre bornes de l'enroulement (enroulement analysé affecté) | 0-1-2 | 0-1-2 | 0-1-2 | 8 | 3 | 0 |
| 9) Défaut entre bornes de l'enroulement (autre enroulement d'une même phase affecté) | 0-1-2 | 0-1-2 | 0 | 8 | 3 | 0 |
| 10) Une spire en court-circuit | 0-1-2 | 0 | 0 | 0 | 0-1-2 | 0 |
| 11) Plusieurs spires en court-circuit | 0-1-2 | 0-1 | 0-1 | 4 | 2 | 0 |
| 12) Court-circuit sur la seule phase adjacente | 0-1 | 0 | 0 | 2 | 0 | 0 |

(suite)

| Types de fautes | $\rho_1$ | $\rho_2$ | $\rho_3$ | $CR_f$ | $CR_k$ | $CR_n$ |
|---|---|---|---|---|---|---|
| 13) Court-circuit sur une autre phase que sur la seule phase adjacente | 0-1 | 0 | 0 | 1 | 0 | 0 |
| 14) Enroulement déplacé ou flambage de l'enroulement intérieur | 0-1 | 0-1 | 0 | 0 | 0 | 0 |
| 15) Enroulement endommagé | 0 | 0 | 0-1 | 0 | 0 | 0-1 |
| 16) Enroulement déplacé et endommagé | 0-1 | 0-1 | 0-1 | 0 | 0 | 0-1 |
| 17) Mauvaise continuité | 0-1-2 | 0-1-2 | 0-1-2 | 0-1 | 9 | 0 |
| 18) Une des bornes de l'enroulement mesuré mise à la terre | 1-2 | 0-1 | 0-1 | 0 | 0 | 0-1 |
| 19) Une des bornes d'une autre phase que celle de l'enroulement mesuré mise à la terre | 1-2 | 0-1-2 | 0 | 9-0 | 0-1-2 | 0-1 |
| 20) Une des bornes d'un autre enroulement de la même phase que l'enroulement mesuré mise à la terre | 0 | 0 | 0-1 | 0 | 0 | 0-1 |

La comparaison entre les paramètres calculés et la table de recherche telle que présentée dans le tableau 4 peut être réalisée par un programme informatique développé dans un environnement Matlab®.

L'explication suivante des défauts sera faite en référence à la figure 2.

Les défauts 2 et 3 correspondent à des mauvaises mises à la terre de la cuve 5 ; dans le cas du défaut 3, il s'agit d'une absence de mise à la terre et dans le cas du défaut 2, d'une mise à la terre avec une résistance élevée entre la cuve 5 et la terre (supérieure à 50 Ohms).

Le défaut 4 correspond à une absence de mise à la terre du circuit magnétique 4, c'est à dire à une rupture de la liaison 8.

Les défauts 5 et 6 correspondent à des boucles de courant de circulation mises respectivement à la terre et à un potentiel flottant ; ces boucles entraînent un échauffement du transformateur.

Le défaut 7 correspond à la présence d'une spire additionnelle créant un court circuit sur la phase à laquelle appartient l'enroulement à analyser.

Le défaut 8 correspond à un défaut entre les bornes de l'enroulement à analyser, c'est à dire un court-circuit de l'enroulement entier.

Le défaut 9 correspond à un défaut entre les bornes d'un enroulement appartenant à la même phase que l'enroulement à analyser.

Le défaut 10 correspond à un court-circuit présent sur une spire des enroulements appartenant à la même phase que l'enroulement à analyser. Ce défaut produit un échauffement du transformateur.

Le défaut 11 correspond à un court-circuit présent sur plusieurs spires appartenant à la même phase que l'enroulement à analyser. Ce défaut produit un échauffement du transformateur.

Le défaut 12 correspond à un défaut de court-circuit tel que qu'un court circuit entre spires, entre bornes ou sur une spire additionnelle. Il indique que le défaut se trouve sur une phase à coté de celle où la mesure a été effectuée et que la phase où se trouve le défaut est la seule phase adjacente, c'est à dire immédiatement à coté de la phase où la mesure a été effectuée. Ainsi, si le défaut se trouve sur le noyau central, l'analyse des autres phases produira ce code car la phase centrale est bien la seule phase immédiatement à coté des phases de gauche et de droite.

La défaut 13 correspond également à un défaut de court-circuit tel qu'un court circuit entre spires, entre bornes ou sur une spire additionnelle. Il indique cependant que le défaut n'est pas sur une phase unique se trouvant immédiatement à coté de la phase où la mesure a été effectuée. Ainsi, si le défaut se trouve sur le noyau de gauche, l'analyse de la phase centrale produira ce code car il y a bien deux phases immédiatement à coté de la phase centrale et non une seule.

Le défaut 14 correspond à un déplacement axial de l'enroulement à analyser sans que ce dernier soit cependant trop endommagé localement ou à un flambage d'un enroulement intérieur.

Le défaut 15 correspond à un endommagement mécanique local sur l'enroulement à analyser.

Le défaut 16 cumule les défauts 14 et 15.

Le défaut 17 correspond à une mauvaise continuité électrique dans l'enroulement à analyser. Cette mauvaise continuité peut être liée à un mauvais contact de mesure.

Le défaut 18 correspond à la mise à la terre d'une des bornes de l'enroulement à analyser.

Le défaut 19 correspond à la mise à la terre d'une des bornes d'un enroulement appartenant à une autre phase que celle de l'enroulement à analyser.

Le défaut 20 correspond à la mise à la terre d'une des bornes d'un enroulement différent de l'enroulement à analyser mais appartenant à la même phase.

Les défauts 18, 19 et 20 sont davantage des défauts de mesure.

Ainsi, en comparant les codes 101001 associés aux courbes de la figure 3 avec les défauts listés dans le tableau 4, on en déduit la présence d'un défaut de type 16 ou 18. On peut écarter un problème de mesure de type 18 en refaisant la mesure et en déduire ou non la présence d'un défaut de type 16, c'est à dire d'un enroulement déplacé et endommagé.

Bien entendu, l'invention n'est pas limitée au mode de réalisation qui vient d'être décrit.

Notamment, les étapes de calcul de paramètres et de recherche dans la table de recherche réalisées par des moyens logiciels peuvent être également réalisées par des opérateurs.

De même, les valeurs des codes ont été données à titre indicatif mais peuvent être remplacées par d'autres valeurs adaptées à d'autres outils logiciels.

## Revendications

1.  Procédé pour diagnostiquer un défaut sur un enroulement de transformateur comportant les étapes suivantes:

    - mesure de l'impédance dudit enroulement en fonction de la fréquence, ladite mesure étant représentée sous la forme d'un premier gain (k) en tension,
    - comparaison de ladite mesure de l'impédance avec une mesure de référence représentée sous la forme d'un deuxième gain (k') en tension, ladite comparaison incluant une étape de calcul de trois premiers paramètres, chacun desdits trois premiers paramètres étant un coefficient de corrélation ($\rho_1$, $\rho_2$, $\rho_3$,) desdits premier et deuxième gains (k, k') dans trois gammes de fréquence différentes,

    ledit procédé étant **caractérisé en ce qu'**il comporte

    - une étape de détermination de la variation relative d'au moins un quatrième paramètre ($CR_k$, $CR_f$, $CR_n$), ledit quatrième paramètre étant une grandeur physique caractéristique dudit transformateur, ladite variation relative étant obtenue en comparant lesdits premier et deuxième gains (k, k'),
    - une étape qui associe un code de diagnostic à chacun desdits trois premiers paramètres et à ladite variation relative dudit quatrième paramètre, et
    - une étape de détermination de la présence d'un défaut et d'identification dudit, défaut en comparant chaque code de diagnostic avec des codes enregistrés.

2.  Procédé selon la revendication 1 **caractérisé en ce que** ledit quatrième paramètre est choisi parmi le gain minimal, la fréquence de résonance fondamentale ou le nombre de fréquences de résonance présentes au-delà d'une fréquence prédéterminée.

3.  Procédé selon la revendication précédente **caractérisé en ce que** ledit gain minimal est déterminé pour une fréquence inférieure à 10 kHz.

4.  Procédé selon l'une des revendications précédentes **caractérisé en ce que** lesdites trois gammes de fréquence différentes sont respectivement [1kHz-10kHz], [10kHz-100kHz] et [100kHz-1MHz].

5.  Procédé selon l'une des revendications précédentes, **caractérisé en ce qu'**il comporte une étape de détermination de la variation relative d'au moins un cinquième et un sixième paramètre, lesdits cinquième et sixième paramètres étant caractéristiques dudit transformateur, ladite variation relative étant obtenue en comparant lesdits premier et deuxième gain.

6.  Procédé selon la revendication précédente, **caractérisé en ce que** ledit quatrième paramètre est le gain minimal, ledit cinquième paramètre est la fréquence de résonance fondamentale et ledit sixième paramètre est le nombre de fréquences de résonance présentes au-delà d'une fréquence prédéterminée.

7.  Procédé selon l'une des revendications précédentes, **caractérisé en ce que** chaque code de diagnostic indique l'appartenance d'un desdits paramètres à une gamme de valeurs prédéterminée.

8.  Procédé selon l'une des revendications précédentes, **caractérisé en ce que** les codes de référence sont enregistrés dans une table de recherche.

## Claims

**1.** A method of diagnosing a fault on a transformer winding, the method comprising the following steps:

- measuring the impedance on said winding as a function of frequency, said measurement being represented in the form of a first voltage gain (k);
- comparing said impedance measurement with a reference measurement represented in the form of a second voltage gain (k'), said comparison including a step of calculating three first parameters, each of said three first parameters being a correlation coefficient ($\rho_1$, $\rho_2$, $\rho_3$), between said first and second gains (k, k') over three different frequency ranges;

said method being **characterized in that** it comprises:

- a step of determining the relative variation of at least a fourth parameter ($CR_k$, $CR_f$, $CR_n$), said fourth parameter being a physical magnitude characteristic of said transformer, said relative variation being obtained by comparing said first and second gains (k, k');
- a step that associates a diagnosis code with each of said three first parameters and with said relative variation of said fourth parameter; and
- a step of determining the presence of a fault and of identifying said fault by comparing each diagnosis code with stored codes.

**2.** A method according to claim 1, **characterized in that** said fourth parameter is selected from minimum gain, fundamental resonant frequency, and number of resonant frequencies present above a predetermined frequency.

**3.** A method according to the preceding claim, **characterized in that** said minimum gain is determined for a frequency below 10 kHz.

**4.** A method according to any preceding claim, **characterized in that** said three different frequency ranges are respectively: [1 kHz to 10 kHz], [10 kHz to 100 kHz], and [100 kHz to 1 MHz].

**5.** A method according to any preceding claim, **characterized in that** it includes a step of determining the relative variation of at least a fifth parameter and a sixth parameter, said fifth and sixth parameters being characteristics of said transformer, said relative variation being obtained by comparing said first and second gains.

**6.** A method according to the preceding claim, **characterized in that** said fourth parameter is minimum gain, said fifth parameter is fundamental resonant frequency, and said sixth parameter is number of resonant frequencies present above a predetermined frequency.

**7.** A method according to any preceding claim, **characterized in that** each diagnosis code indicates whether a respective one of said parameters belongs to a predetermined range of values.

**8.** A method according to any preceding claim, **characterized in that** the reference codes are stored in a search table.

## Patentansprüche

**1.** Verfahren zur Diagnose eines Fehlers in einer Transformatorwicklung mit folgenden Schritten:

- Messen der Impedanz der Wicklung in Abhängigkeit von der Frequenz, wobei die Messung in Form einer ersten Spannungsverstärkung (k) dargestellt wird,
- Vergleichen der Impedanzmessung mit einer Referenzmessung, die in Form einer zweiten Spannungsverstärkung (k') dargestellt wird, wobei der Vergleich einen Schritt zum Berechnen von drei ersten Parametern beinhaltet, wobei jeder der drei ersten Parameter ein Korrelationskoeffizient ($\rho_1$, $\rho_2$, $\rho_3$) der ersten und der zweiten Verstärkung (k, k') in drei verschiedenen Frequenzbereichen ist,

wobei das Verfahren **dadurch gekennzeichnet ist, dass** es umfasst:

- einen Schritt zum Ermitteln der relativen Schwankung zumindest eines vierten Parameters ($CR_k$, $CR_f$, $CR_n$), wobei der vierte Parameter eine physikalische Kenngröße des Transformators ist, wobei die relative Schwankung durch Vergleichen der ersten und der zweiten Verstärkung (k, k') erhalten wird,
- einen Schritt zum Zuordnen eines Diagnosecodes zu jedem der drei ersten Parameter und zu der relativen Schwankung des vierten Parameters,
- einen Schritt zum Ermitteln eines vorhandenen Fehlers und zum Identifizieren des Fehlers durch Vergleichen eines jeden Diagnosecodes mit abgelegten Codes.

2. Verfahren nach Anspruch 1, **dadurch gekennzeichnet, dass** der vierte Parameter ausgewählt ist aus der Gruppe Mindestverstärkung, Grundresonanzfrequenz bzw. Anzahl der über eine vorbestimmte Frequenz hinaus vorhandenen Resonanzfrequenzen.

3. Verfahren nach dem vorangehenden Anspruch, **dadurch gekennzeichnet, dass** die Mindestverstärkung für eine Frequenz unter 10 kHz bestimmt wird.

4. Verfahren nach einem der vorangehenden Ansprüche, **dadurch gekennzeichnet, dass** die drei verschiedenen Frequenzbereiche [1 kHz - 10 kHz], [10 kHz - 100 kHz] bzw. [100 kHz - 1 MHz] sind.

5. Verfahren nach einem der vorangehenden Ansprüche, **dadurch gekennzeichnet, dass** es einen Schritt zum Ermitteln der relativen Schwankung zumindest eines fünften und eines sechsten Parameters umfasst, wobei der fünfte und der sechste Parameter kennzeichnend für den Transformator sind, wobei die relative Schwankung durch Vergleichen der ersten und der zweiten Verstärkung erhalten wird.

6. Verfahren nach dem vorangehenden Anspruch, **dadurch gekennzeichnet, dass** der vierte Parameter die Mindestverstärkung ist, wobei der fünfte Parameter die Grundresonanzfrequenz und der sechste Parameter die Anzahl der über eine vorbestimmte Frequenz hinaus vorhandenen Resonanzfrequenzen ist.

7. Verfahren nach einem der vorangehenden Ansprüche, **dadurch gekennzeichnet, dass** jeder Diagnosecode die Zugehörigkeit eines der Parameter zu einem vorgestimmten Wertebereich angibt.

8. Verfahren nach einem der vorangehenden Ansprüche, **dadurch gekennzeichnet, dass** die Referenzcodes in einer Nachschlagtabelle abgelegt sind.

**Figure 1**

**Figure 2**

**Figure 3**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S.A. RYDER.** Methods for comparing frequency response analysis measurements. *IEEE Int. Symp. on Electrical Insulation,* 2002, vol. 7